# EUROPEAN PATENT SPECIFICATION

(11) **EP 4 439 078 B1**
(45) Date of publication and mention of the grant of the patent: **27.08.2025**
(21) Application number: 24162876.7
(22) Date of filing: 12.03.2024
(51) Int. Cl.: G01R 1/04, G01R 31/28

(54) **METHOD FOR POSITIONING SEMICONDUCTOR DEVICES AND CORRESPONDING POSITIONING APPARATUS**
VERFAHREN ZUR POSITIONIERUNG VON HALBLEITERBAUELEMENTEN UND ENTSPRECHENDE POSITIONIERUNGSVORRICHTUNG
PROCÉDÉ DE POSITIONNEMENT DE DISPOSITIFS SEMI-CONDUCTEURS ET APPAREIL DE POSITIONNEMENT CORRESPONDANT

(30) Priority: 31.03.2023 IT 202300006327
(43) Date of publication of application: 02.10.2024
(73) Proprietor: STMicroelectronics International N.V., 1228 Plan-les-Ouates, Geneva (CH)
(72) Inventor: AVOCI UGWIRI, Moise, I-81055 Caserta (IT); FILPI, Giuliano, I-81100 Caserta (IT); COSTE, Fabrice, F-84130 Le Pontet (PACA) (FR); GRIMA, Alex, Xewkija (Gozo), XWK 1234 (MT); PERALTA, Pedro Jr Santos, 4118 Silang (Cavite) (PH)
(74) Representative: Buzzi, Notaro & Antonielli d'Oulx S.p.A.

(56) References cited:
- CN-A- 1 167 564
- US-A1- 2003 001 600

## Description

### Technical field

The description relates to semiconductor devices.

For instance, embodiments as described herein can be applied in producing Wafer Level Chip Scale Package, WLCSP (integrated circuit) semiconductor devices.

### Background

The designation Wafer Level Chip Scale Package, WLCSP applies to a technology where integrated circuits are packaged at the wafer level, rather than as individual units after dicing them from a wafer.

The final device resulting from WLCSP processing is a semiconductor chip or die with an array of bumps or solder balls attached at an input/output pitch that facilitates circuit board assembly processes. The resulting package is thus essentially of the same size of the chip or die.

WLCSP technology advantageously dispenses with bond wires or similar connections and, in addition to a reduced package size, may also provide a reduced inductance from a die to a substrate (a printed circuit board, PCB, for instance).

One WLCSP category called "fan-in" limits redirection of solder balls to pads only on top of chip then sizing at chip size but also have no overmold then exposing chip substrate sidewall.

A problem that may arise in applying WLCSP technology is related to package insertion in test socket cavity when aligning (centering) a device on contact pins such as so-called "pogo" pins. These are electrical connectors that are used in view of their resilience to mechanical shock and vibration.

This handling might advantageously take place in a centering phase where a module is placed in a "personalization" socket taking advantage of auto-centering chamfers.

It is noted that applying such an approach to WLCSP devices may not be particularly attractive, as this may result in undesired damage of corner, sidewall and active face of the die.

This militates against personalizing (customizing) fan-in WLCSP packages when using reel-to-reel handling machines using pick&place technology, for instance vs. wafer level personalization before dicing.

Document US 2003/001600 A1 discloses an accommodation portion for a semiconductor device to be mounted formed of an accommodation portion of a positioning member that is restricted in its position to a socket body and supported on the same, and an accommodation portion of a positioning member that is supported on the socket body relatively movably with respect to the socket body.

Document CN 1 167 564 A discloses a method of positioning integrated circuits (ICs) and an IC handler wherein a positioning wall piece encloses a table, with two pairs of inner faces, each pair of which are facing each other, and lower portions of each pair formed into vertical faces and mutually separated with a distance corresponding to outermost edges of the IC, with upper portions of each pair formed into slope faces whose distance is gradually made longer in an upward direction. An elastic member elastically supports the positioning wall piece, which is capable of moving vertically. The vertical mechanism is located above the positioning mechanism and pushes the positioning wall piece downwardly so as to correspond the upper face of the table to the upper portions when the IC is mounted on the table, and allows movement of the positioning wall piece upwardly so as to correct a horizontal deviation of the IC by the slope faces and to position the same by the vertical faces after the IC is mounted on the table.

### Object and summary

Solutions as described herein aim at addressing the issues discussed in the foregoing.

Such an object can be achieved via a method having the features set forth in the claims that follow.

One or more embodiments relate to a corresponding apparatus.

The claims are an integral part of the technical teaching provided in respect of the embodiments.

In solutions as described herein a tool such as a vacuum cup can be used to pick up a die and to co-operate with a "nest" to facilitate mechanical pre-alignment at a nest level without unduly constraining placement accuracy at a "socket" level.

In that way, the edges of an alignment device may come into contact with the back or bottom side of the die which is usually provided with a protective layer (coating), instead of coming into contact to the front or top (active) side, sidewall or corner which are fragile.

Solutions as described herein facilitate pick&place sampling and preproduction activities, making these activities faster by enhancing alignment accuracy in comparison with conventional solutions, where sampling and preproduction are at wafer level, thus being expensive and hardly compatible with desired time-to-market strategies.

### Brief description of the several views of the drawings

One or more embodiments will now be described, by way of example only, with reference to the annexed figures, wherein:
Figure 1 is exemplary of placing a semiconductor device in a personalization socket using auto-centering chamfers;
Figures 2 and 3 (where Figure 3 is a view of the portion of Figure 2 indicated by the arrow III) are exemplary of possible damage that might result from applying the solution of Figure 1 to devices obtained via Wafer Level Chip Scale Package, WLCSP technology;
Figure 4 is a side view of a WLCSP device showing features that can be exploited in embodiments of the present description;
Figures 5A to 5E are exemplary of steps in handling a semiconductor device according to embodiments of the present description;
Figure 6 is exemplary of a conventional personalization flow of a WLCSP device; and
Figure 7 is exemplary of a personalization flow of a WLCSP device that can be facilitated by embodiments of the present description.

Corresponding numerals and symbols in the different figures generally refer to corresponding parts unless otherwise indicated.

The figures are drawn to clearly illustrate the relevant aspects of the embodiments and are not necessarily drawn to scale.

The edges of features drawn in the figures do not necessarily indicate the termination of the extent of the feature.

### Detailed description

In the ensuing description one or more specific details are illustrated, aimed at providing an in-depth understanding of examples of embodiments of this description. The embodiments may be obtained without one or more of the specific details, or with other methods, components, materials, etc. In other cases, known structures, materials, or operations are not illustrated or described in detail so that certain aspects of embodiments will not be obscured.

Reference to "an embodiment" or "one embodiment" in the framework of the present description is intended to indicate that a particular configuration, structure, or characteristic described in relation to the embodiment is comprised in at least one embodiment. Hence, phrases such as "in an embodiment" or "in one embodiment" that may be present in one or more points of the present description do not necessarily refer to one and the same embodiment.

Moreover, particular configurations, structures, or characteristics may be combined in any adequate way in one or more embodiments within the scope of the appended claims.

The headings/references used herein are provided merely for convenience and hence do not define the extent of protection or the scope of the embodiments.

For simplicity and ease of explanation, throughout this description, and unless the context indicates otherwise, like parts or elements may be indicated in the various figures with like reference signs, and a corresponding description will not be repeated for each and every figure.

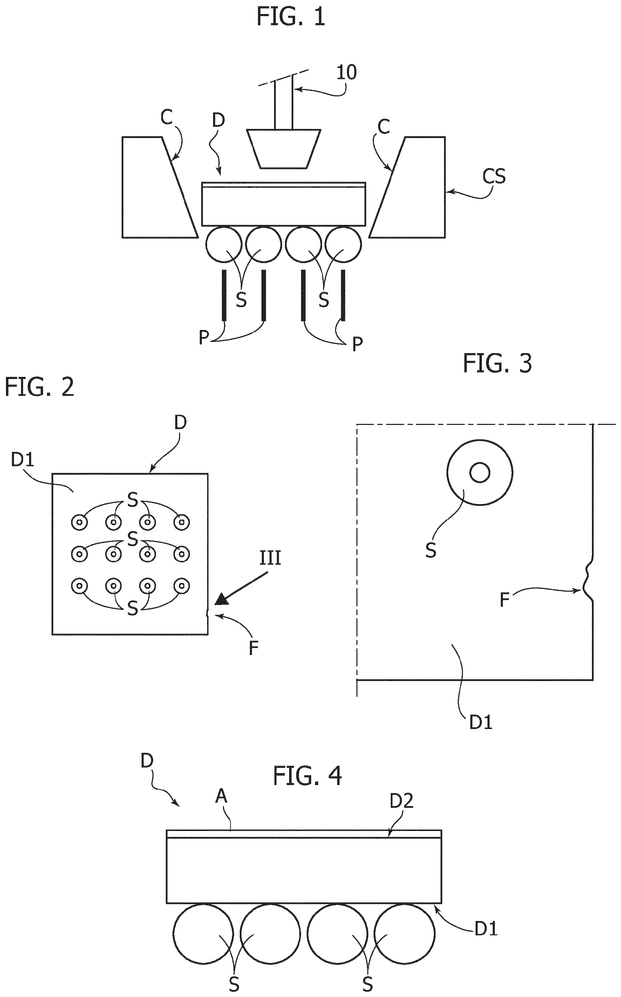

Figure 1 is exemplary of placing an (integrated circuit, IC) semiconductor device D in a "personalization" socket CS provided with auto-centering chamfers C.

This is essentially a mechanical centering method that can be implemented using a pick&place tool 10 (of a known type) that picks the device D (from above in the case illustrated) and places, namely inserts or advances, the device D in a personalization socket CS taking advantage of auto-centering chamfers C provided therein.

Such an approach may be considered for centering a WLCSP device on pogo-pins P, namely electrical connectors that are used in view of their resilience to mechanical shock and vibration.

It is noted that applying such an approach to a WLCSP device may result in undesired damage F at the edge of the front or top surface, the sidewall or the corners of the chip or die as schematically illustrated in Figures 2 and **3****,** where Figure 3 is a view of the portion of Figure 2 indicated by the arrow III.

In fact, the final device resulting from WLCSP processing is a semiconductor chip or die (as used herein, these two terms are considered as synonymous) with an array of bumps or solder balls S attached to a front or top surface D1 in order to facilitate circuit board assembly processes (coupling to pogo-pins P, for instance) .

In an arrangement as exemplified in Figure 1, if applied to a WLCSP device, the edges of the alignment chamfers C will come into contact with the front or top (active) side, which may be fragile (bare silicon, for instance), thus possibly producing damage as exemplified by the reference F.

This militates against personalizing fan-in WLCSP packages using reel-to-reel handling machines using pick&place technology, for instance.

One or more embodiments are based on the recognition that the structure of a WLCSP device D may be as exemplified in Figure 4 and thus comprise a device body having:
an - expectedly fragile - front or top surface D1 of unprotected silicon, for instance, carrying an array of bumps or solder balls S configured to facilitate circuit board assembly processes, by centered (aligned) mounting on a corresponding array of pogo-pins, for instance, and
a back or bottom surface D2 provided with a protective layer A (a coating of metal having a thickness of 20-25 microns, for instance).

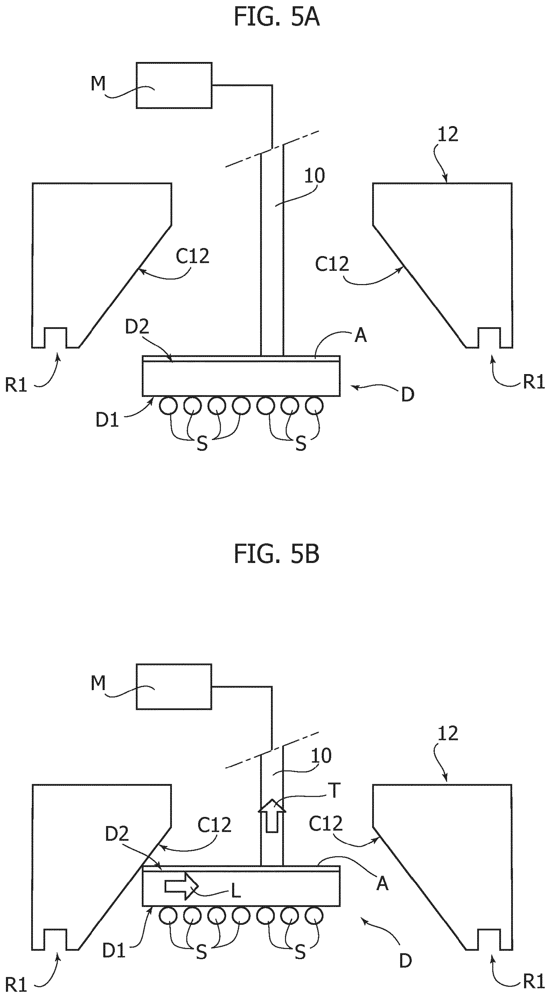

These features of a WLCSP device - essentially the fact that a WLCSP device D has (only) one "robust" and non-active surface (the coated back or bottom side D2) - can be exploited in handling a WLCSP device with the steps illustrated in Figures 5A to 5E, in order to align onto an array of pogo-pins P for electrical testing, for instance.

Figures 5A to 5E are exemplary of steps in aligning electrical contact formations (such as bumps or solder balls S in an array of electrical contact formations carried by a first surface D1 of a semiconductor device D) with electrically conductive pins in an array of electrically conductive pins such as "pogo" pins P.

As used herein, "aligning" is used to indicate the action of achieving a desired mutual positioning of electrical contact formations (bumps or solder balls, for instance) S and electrically conductive pins ("pogo" pins, for instance) P, in view of achieving electrical coupling
While the wording centering may also be used in more common language, the wording aligning may represent a more accurate description of such a desired mutual positioning aiming at having an array electrical contact formations facing a complementary array of electrically conductive pins lying in an adjacent plane.

In fact, while desired to be mutually positioned "in register" with each other, an array of electrical contact formations S and an array of electrically conductive pins P may not have a central point on a same axis.

One or more embodiments as exemplified in Figures 5A to 5E may take advantage of the fact that a semiconductor device D such as a WLCSP device comprises, opposite the first surface D1, a second surface D2 protected by a protection layer such as the layer A.

It will be otherwise appreciated that the sequence of steps of Figures 5A to 5E is merely exemplary insofar as:
one or more steps illustrated in Figures 5A to 5E can be omitted, performed in a different manner (with other tools, such as a pick-up tool 10 different from a vacuum cup, for instance) and/or replaced by other steps.
additional steps may be added.
one or more steps can be carried out in a sequence different from the sequence illustrated.

The steps illustrated in Figures 5A to 5E provide a mechanical alignment (centering) method that can be implemented using a pick&place tool 10 (such as a vacuum cup of a known type) that picks the device D (from above in the case illustrated) and aligns the device D with respect to a "nest" member 12.

As illustrated, such alignment (briefly, centering) is facilitated by chamfers C12 provided in the nest member 12.

As illustrated, the chamfers C12 are upwardly converging chamfers and the device D is aligned (centered) with respect to the nest member 12 by being pulled upwardly by the tool (vacuum cup) 10 as indicated by an upward arrow T at the top of Figure 5B.

As illustrated, the chamfered surface C12 in the first alignment member (nest member) 12 comprises a tapered surface (frusto-conical, for instance) converging in a tapering direction (here, in the upward direction of the arrow T) from a first end at the bottom of the member 12 towards a second end at the top of the member 12.

As visible in Figures 5A to 5C, aligning the semiconductor device D to the first alignment member 12 may thus comprise picking - via a tool 10 such as a vacuum cup 10 - the semiconductor device D (Figure 5A) and advancing the semiconductor device D (picked at the second surface D2, here pointing upwardly) with respect to the chamfered surface C12 in the tapering direction thereof with the second surface D2 (protected by the layer A) exposed to the chamfered (tapered) surface C12.

In a positioning apparatus as illustrated in Figures 5A to 5E such an pick-up advance/lifting movement (here exemplified by an arrow T in Figure 5B) can be imparted to the tool 10 and/or the device D carried thereby via a motorization M (of a known type to those of skill in the art of pick&place machinery, for instance).

Alignment can thus take place during lifting the device D in response to the device D possibly sliding (in a lateral horizontal direction, for instance, here exemplified by an arrow L in Figure 5B) under the picker tool 10 or with the picker tool 10 capable of moving correspondingly sidewise with respect to the nest member 12.

In that way, in response to the displacement with respect to the chamfered surface C12 of the nest member 12, the device (die) D can be adequately aligned (already) during the "pick" phase, with only the robust side (the back or bottom side D2 protected by the layer A) exposed to possible interaction (sliding, for instance) with the chamfers C12 (and with the picking tool 10).

Thanks to the perfect alignment of the nest (member 12) and the device D, the risk of damage at the (fragile) surface D1 as exemplified by reference F in Figure 2 and 3 is thus effectively countered.

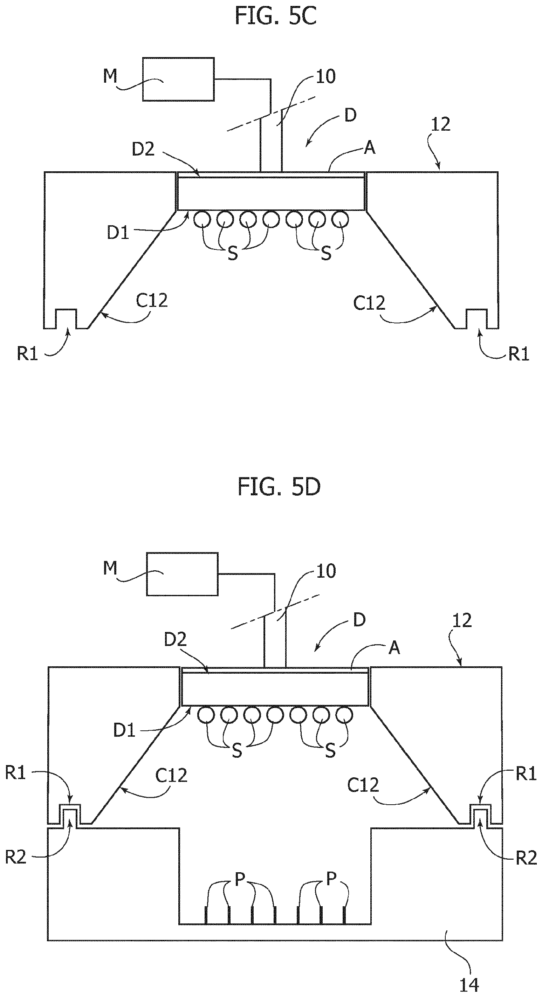

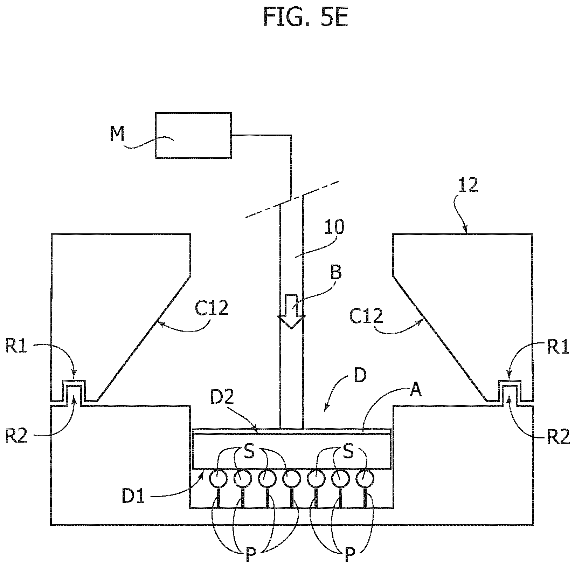

As illustrated in Figure 5D, the nest member 12 - having the device D adequately aligned therein (during the pick phase: see Figure 5C), can be coupled, and thus aligned, with a mating socket member 14 to let the bumps or balls S in the device D finally "land" (Figure 5E) on the pins P that are aligned (in a manner known per se to those of skill in the art) with the socket member 14.

In an apparatus as depicted in Figures 5A to 5E, such a landing movement can be in response to the picking tool 10 carrying the aligned (centered) device D being lowered towards the socket member 14 (and the pins P) as indicated by an arrow L in Figure 5E via a motorization of a known type. This can be the same motorization M used for the picking/lifting movement T used for aligning the device D with the nest member 12 as illustrated Figure 5A to 5C.

Provided the nest member 12 and the socket member 14 are properly mutually aligned, the device D - and, more to the point, the bumps or balls S at the underside of the device D - will land on the pogo-pins P in (precise) alignment therewith as desired, in view of subsequent coupling via soldering, for instance.

This result can be achieved by providing the nest member 12 and the socket member 14 with mating formations ("fiducials") R1, R2 configured to facilitate (accurate) mutual alignment.

As illustrated, these fiducials R1, R2 may comprise cavities R1 at the (here lower) surface of the nest member 12 configured to be engaged by mating projections R2 (pins, for instance) at the (here upper) surface of the socket member 14.

In a complementary manner, these fiducials R1, R2 may comprise cavities at the surface of the socket member 14 configured to be engaged by corresponding mating projections (pins, for instance) at the adjacent surface of the nest member 12.

Also mixed arrangements, with the fiducials R1, R2 comprising cavities and projections carried by both the nest member 12 and the socket member 14 are feasible.

Advantageously, the fiducials R1, R2 may comprises self-centering mating features configured to mutually co-operate in a centering cone arrangement. In various embodiments, such features may include ramp formations protruding from the second alignment member (socket member 14) to engage the chamfered surface C12 in the first alignment member (nest member 12) in a centering cone arrangement.

Whatever the specific implementation of the mutual alignment features R1, R2, the device D (which is aligned with the nest member 12) and more to the point, the bumps or balls S at the first surface D1, will be aligned as desired with the pogo-pins P (which are aligned with the socket member 14).

To summarize, an apparatus as illustrated in Figures 5A to 5E comprises a first alignment member (the nest member 12) and a second alignment member (the socket member 14) that configured to be coupled in a mutually aligned relationship (via centering features such as the "fiducials" R1, R2, for instance).

During the "pick" phase of Figures 5A to 5C, the semiconductor device D (and thus the formations S at the surface D1) are aligned to the first alignment member 12.

This can be achieved by exposing to the chamfered surface C12 in the nest member 12 (only) the second surface D2 of the device D, which is protected by the protective layer A.

As illustrated in Figures 5D and 5E, the second centering member (the socket member 14) is aligned with respect to the array of electrically conductive pins P.

As a result, the array of electrical contact formations (bumps or balls S) in the device D ends up by being aligned with respect to the array of electrically conductive pins P as desired in so far as the first alignment member (nest member 12) and the second alignment member (socket member 14) are mutually coupled.

As illustrated, this may take place in response to the device D being "landed" onto the pins P in an aligned relationship due to the presence of the complementary formations R1, R2, for instance) with the alignment members 12 and 14 having in turn aligned therewith:
i) the array of electrical contact formations S in the semiconductor device D (in the case of the nest member 12), and
ii) the array of electrically conductive pins P (in the case of the socket member 14).

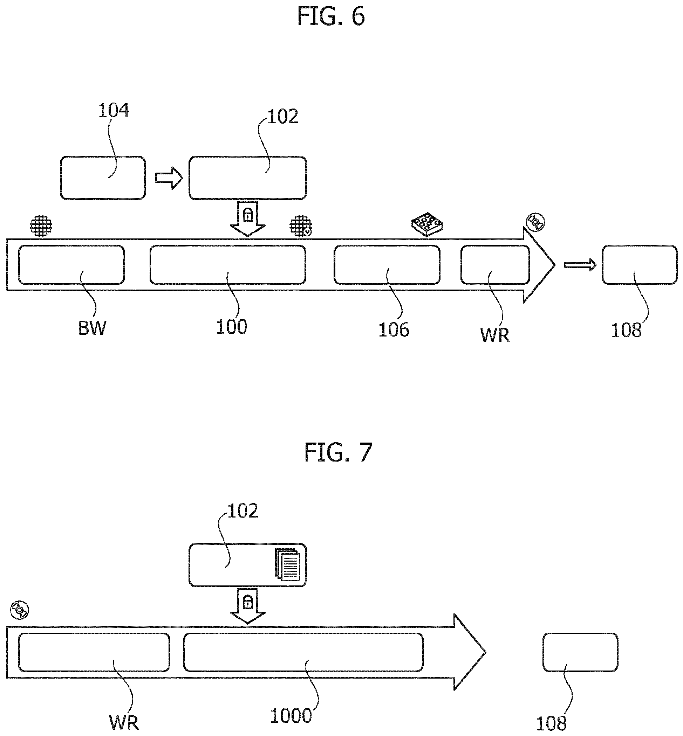

Figure 6 is exemplary of a conventional personalization flow of a WLCSP device based on waferlevel personalization (as represented by block 100) of a bumped wafer BW based on design data such as operating system, OS, profile and data generation information 102 as provided by a source such as a telecom operator 104.

As illustrated in Figure 6, the results of waferlevel personalization of block 100 can be subjected to singulation (wafer dicing) as represented by block 106, after which WLCSP devices in reel form WR can be made available to delivery as represented by block 108.

Figure 7 is exemplary of a personalization flow of a WLCSP device according to embodiments of the present description.

In such a flow, personalization as represented by block 1000 in Figure 7 can be performed based on personalization information 102 on pick&place equipment as illustrated in Figures 5A to 5E operating on WLCSP devices that already are in reel form WR in view of delivery as represented by block 108.

Without prejudice to the underlying principles, the details and embodiments may vary, even significantly, with respect to what has been described by way of example only without departing from the extent of protection.

The extent of protection is determined by the annexed claims.

## Claims

1. A method, comprising:
aligning electrical contact formations (S) in an array of electrical contact formations on a first surface (D1) of a semiconductor device (D) with electrically conductive pins in an array of electrically conductive pins (P), wherein the semiconductor device (D) comprises, opposite the first surface (D1), a second surface (D2) protected by a protection layer (A), wherein the method comprises:
aligning the semiconductor device (D) to a first alignment member (12) by exposing said protected second surface (D2) of the semiconductor device (D) to a chamfered surface (C12) in the first alignment member (12), and
aligning the first alignment member (12) with a second alignment member (14) having the array of electrically conductive pins (P) aligned therewith, wherein the array of electrical contact formations (S) is aligned with respect to the array of electrically conductive pins (P) in response to the first (12) and second (14) alignment members being mutually aligned (R1, R2).

2. The method of claim 1, wherein:
the chamfered surface (C12) in the first alignment member (12) comprises a tapered surface converging in a tapering direction from a first end towards a second end of the first alignment member (12), and
aligning the semiconductor device (D) to the first alignment member (12) comprises advancing (U) the semiconductor device (D) with respect to said chamfered surface (C12) in said tapering direction with the protected second surface (D2) exposed to said chamfered surface (C12).

3. The method of claim 1 or claim 2, wherein the first (12) and second (14) alignment members have complementary mating formations (R1, R2) wherein the first (12) and second (14) alignment members are mutually aligned via said complementary mating formations (R1, R2).

4. The method of claim 3, wherein the complementary mating formations (R1, R2) comprise complementary mating cavities (R1) and protrusions (R2) carried by the first (12) and second (14) alignment members.

5. The method of any of the previous claims, wherein the semiconductor device (D) comprises a Wafer Level Chip Scale Package, WLCSP semiconductor device.

6. An apparatus (10, 12, 14) for use in performing the method of any of claims 1 to 5, the apparatus comprising:
a first alignment member (12) configured to have said semiconductor device (D) aligned therewith in response to said protected second surface (D2) of the semiconductor device (D) being exposed to a chamfered surface (C12) in the first alignment member (12),
a second alignment member (14) configured to have the array of electrically conductive pins (P) aligned therewith, and
alignment formations (R1, R2) configured to align the first alignment member (12) with the second alignment member (14), wherein the array of electrical contact formations (S) is aligned with respect to the array of electrically conductive pins (P) in response to the first (12) and second (14) alignment members being mutually aligned.

7. The apparatus (10, 12, 14) of claim 6, wherein:
the chamfered surface (C12) in the first alignment member (12) comprises a tapered surface converging in a tapering direction from a first end towards a second end of the first alignment member (12), and
the apparatus comprises a picking tool (M, 10) configured to advance (U) the semiconductor device (D) with respect to said chamfered surface (C12) in said tapering direction with the protected second surface (D2) exposed to said chamfered surface (C12).

8. The apparatus (10, 12, 14) of claim 6 or claim 7, wherein the first (12) and second (14) alignment members have complementary mating formations (R1, R2) wherein the first (12) and second (14) alignment members are mutually aligned in response to said complementary mating formations (R1, R2) being mutually engaged.

9. The apparatus (10, 12, 14) of claim 8, wherein the complementary mating formations comprise complementary mating cavities (R1) and protrusions (R2) carried by the first (12) and second (14) alignment members.

## Patentansprüche

1. Verfahren, das Folgendes umfasst:
Ausrichten elektrischer Kontaktformationen (S) in einem Array elektrischer Kontaktformationen auf einer ersten Oberfläche (D1) einer Halbleitervorrichtung (D) mit elektrisch leitfähigen Stiften in einem Array elektrisch leitfähiger Stifte (P), wobei die Halbleitervorrichtung (D) gegenüber der ersten Oberfläche (D1) eine zweite Oberfläche (D2) umfasst, die durch eine Schutzschicht (A) geschützt ist, wobei das Verfahren Folgendes umfasst:
Ausrichten der Halbleitervorrichtung (D) an einem ersten Ausrichtungselement (12), indem die geschützte zweite Oberfläche (D2) der Halbleitervorrichtung (D) einer abgeschrägten Oberfläche (C12) in dem ersten Ausrichtungselement (12) ausgesetzt wird, und
Ausrichten des ersten Ausrichtungselements (12) an einem zweiten Ausrichtungselement (14), zu dem das Array elektrisch leitfähiger Stifte (P) ausgerichtet ist, wobei das Array elektrischer Kontaktformationen (S) in Bezug auf das Array elektrisch leitfähiger Stifte (P) als Reaktion darauf ausgerichtet wird, dass das erste (12) und das zweite (14) Ausrichtungselement zueinander ausgerichtet sind (R1, R2).

2. Verfahren nach Anspruch 1, wobei:
die abgeschrägte Oberfläche (C12) in dem ersten Ausrichtungselement (12) eine konische Oberfläche umfasst, die in einer sich verjüngenden Richtung von einem ersten Ende zu einem zweiten Ende des ersten Ausrichtungselements (12) konvergiert, und
das Ausrichten der Halbleitervorrichtung (D) an dem ersten Ausrichtungselement (12) das Vorschieben (U) der Halbleitervorrichtung (D) in Bezug auf die abgeschrägte Oberfläche (C12) in der sich verjüngenden Richtung umfasst, wobei die geschützte zweite Oberfläche (D2) der abgeschrägten Oberfläche (C12) ausgesetzt ist.

3. Verfahren nach Anspruch 1 oder 2, wobei das erste (12) und das zweite (14) Ausrichtungselement komplementäre Paarungsformationen (R1, R2) aufweisen, wobei das erste (12) und das zweite (14) Ausrichtungselement über die komplementären Paarungsformationen (R1, R2) zueinander ausgerichtet sind.

4. Verfahren nach Anspruch 3, wobei die komplementären Paarungsformationen (R1, R2) komplementäre Paarungshohlräume (R1) und Vorsprünge (R2) umfassen, die von den ersten (12) und zweiten (14) Ausrichtungselementen getragen werden.

5. Verfahren nach einem der vorhergehenden Ansprüche, wobei die Halbleitervorrichtung (D) eine Wafer-Level-Chip-Scale-Package-, WLCSP-Halbleitervorrichtung, umfasst.

6. Vorrichtung (10, 12, 14) zur Verwendung bei der Durchführung des Verfahrens nach einem der Ansprüche 1 bis 5, wobei die Vorrichtung Folgendes umfasst:
ein erstes Ausrichtungselement (12), das so eingerichtet ist, dass es die Halbleitervorrichtung (D) als Reaktion darauf, dass die geschützte zweite Oberfläche (D2) der Halbleitervorrichtung (D) einer abgeschrägten Oberfläche (C12) im ersten Ausrichtungselement (12) ausgesetzt ist, darauf ausrichtet,
ein zweites Ausrichtungselement (14), das so eingerichtet ist, dass das Array elektrisch leitfähiger Stifte (P) darauf ausgerichtet ist, und
Ausrichtungsformationen (R1, R2), die so eingerichtet sind, dass sie das erste Ausrichtungselement (12) mit dem zweiten Ausrichtungselement (14) ausrichten, wobei das Array elektrischer Kontaktformationen (S) in Bezug auf das Array elektrisch leitfähiger Stifte (P) als Reaktion darauf ausgerichtet ist, dass das erste (12) und das zweite (14) Ausrichtungselement zueinander ausgerichtet sind.

7. Vorrichtung (10, 12, 14) nach Anspruch 6, wobei:
die abgeschrägte Oberfläche (C12) in dem ersten Ausrichtungselement (12) eine konische Oberfläche umfasst, die in einer sich verjüngenden Richtung von einem ersten Ende zu einem zweiten Ende des ersten Ausrichtungselements (12) konvergiert, und
die Vorrichtung ein Greifwerkzeug (M, 10) umfasst, das so eingerichtet ist, dass es die Halbleitervorrichtung (D) in Bezug auf die abgeschrägte Oberfläche (C12) in der abgeschrägten Richtung vorschiebt (U), wobei die geschützte zweite Oberfläche (D2) der abgeschrägten Oberfläche (C12) ausgesetzt ist.

8. Vorrichtung (10, 12, 14) nach Anspruch 6 oder Anspruch 7, wobei das erste (12) und das zweite (14) Ausrichtungselement komplementäre Paarungsformationen (R1, R2) aufweisen, wobei das erste (12) und das zweite (14) Ausrichtungselement als Reaktion darauf, dass die komplementären Paarungsformationen (R1, R2) ineinandergreifen, zueinander ausgerichtet sind.

9. Vorrichtung (10, 12, 14) nach Anspruch 8, wobei die komplementären Paarungsformationen komplementäre Paarungshohlräume (R1) und Vorsprünge (R2) umfassen, die von den ersten (12) und zweiten (14) Ausrichtungselementen getragen werden.

## Revendications

1. Procédé comprenant l'opération suivante :
aligner des formations de contact électrique (S) dans un ensemble de formations de contact électrique sur une première surface (D1) d'un dispositif semiconducteur (D) avec des broches électriquement conductrices dans un ensemble de broches électriquement conductrices (P), dans lequel le dispositif semiconducteur (D) comprend, à l'opposé de la première surface (D1), une deuxième surface (D2) protégée par une couche de protection (A), dans lequel le procédé comprend les étapes suivantes :
aligner le dispositif semiconducteur (D) avec un premier élément d'alignement (12) en exposant ladite deuxième surface protégée (D2) du dispositif semiconducteur (D) à une surface chanfreinée (C12) du premier élément d'alignement (12), et
aligner le premier élément d'alignement (12) avec un deuxième élément d'alignement (14) qui est aligné avec l'ensemble de broches électriquement conductrices (P), dans lequel l'ensemble de formations de contact électrique (S) est aligné par rapport à l'ensemble de broches électriquement conductrices (P) en réponse à l'alignement mutuel (R1, R2) des premier (12) et deuxième (14) éléments d'alignement.

2. Procédé selon la revendication 1, dans lequel :
la surface chanfreinée (C12) du premier élément d'alignement (12) comprend une surface effilée convergeant dans une direction d'effilement d'une première extrémité vers une deuxième extrémité du premier élément d'alignement (12), et
l'alignement du dispositif semiconducteur (D) par rapport au premier élément d'alignement (12) comprend le fait de faire avancer (U) le dispositif semiconducteur (D) par rapport à ladite surface chanfreinée (C12) dans ladite direction d'effilement avec la deuxième surface protégée (D2) exposée à ladite surface chanfreinée (C12).

3. Procédé selon la revendication 1 ou 2, dans lequel les premier (12) et deuxième (14) éléments d'alignement ont des formations d'accouplement complémentaires (R1, R2), dans lequel les premier (12) et deuxième (14) éléments d'alignement sont mutuellement alignés par l'intermédiaire desdites formations d'accouplement complémentaires (R1, R2).

4. Procédé selon la revendication 3, dans lequel les formations d'accouplement complémentaires (R1, R2) comprennent des cavités d'accouplement (R1) et des protubérances (R2) complémentaires portées par les premier (12) et deuxième (14) éléments d'alignement.

5. Procédé selon l'une quelconque des revendications précédentes, dans lequel le dispositif semiconducteur (D) comprend un dispositif semiconducteur d'encapsulation sur tranche, ou WLCSP.

6. Appareil (10, 12, 14) destiné à être utilisé pour mettre en œuvre le procédé de l'une quelconque des revendications 1 à 5, l'appareil comprenant :
un premier élément d'alignement (12) configuré pour être aligné avec ledit dispositif semiconducteur (D) lorsque ladite deuxième surface protégée (D2) du dispositif semiconducteur (D) est exposée à une surface chanfreinée (C12) du premier élément d'alignement (12),
un deuxième élément d'alignement (14) configuré pour être aligné avec l'ensemble de broches électriquement conductrices (P), et
des formations d'alignement (R1, R2) configurées pour aligner le premier élément d'alignement (12) avec le deuxième élément d'alignement (14), dans lequel l'ensemble de formations de contact électrique (S) est aligné par rapport à l'ensemble de broches électriquement conductrices (P) en réponse à l'alignement mutuel des premier (12) et deuxième (14) éléments d'alignement.

7. Appareil (10, 12, 14) selon la revendication 6, dans lequel :
la surface chanfreinée (C12) du premier élément d'alignement (12) comprend une surface effilée convergeant dans une direction d'effilement d'une première extrémité vers une deuxième extrémité du premier élément d'alignement (12), et
l'appareil comprend un outil de prélèvement (M, 10) configuré pour faire avancer (U) le dispositif semiconducteur (D) par rapport à ladite surface chanfreinée (C12) dans ladite direction d'effilement avec la deuxième surface protégée (D2) exposée à ladite surface chanfreinée (C12).

8. Appareil (10, 12, 14) selon la revendication 6 ou 7, dans lequel les premier (12) et deuxième (14) éléments d'alignement ont des formations d'accouplement complémentaires (R1, R2), dans lequel les premier (12) et deuxième (14) éléments d'alignement sont mutuellement alignés lorsque lesdites formations d'accouplement complémentaires (R1, R2) sont mutuellement engagées.

9. Appareil (10, 12, 14) selon la revendication 8, dans lequel les formations d'accouplement complémentaires comprennent des cavités d'accouplement (R1) et des protubérances (R2) complémentaires portées par les premier (12) et deuxième (14) éléments d'alignement.
